# EUROPÄISCHE PATENTSCHRIFT

(11) **EP 1 396 718 B1**
(45) Veröffentlichungstag und Bekanntmachung des Hinweises auf die Patenterteilung: **31.10.2007**
(21) Anmeldenummer: 03103259.2
(22) Anmeldetag: 01.09.2003
(51) Int. Cl.: G01N 27/414

(54) **Elektrochemischer Sensor**
Electrochemical sensor
Capteur électrochimique

(30) Priorität: 06.09.2002 DE 10241779
(43) Veröffentlichungstag der Anmeldung: 10.03.2004
(73) Patentinhaber: Mettler-Toledo AG, 8606 Greifensee (CH)
(72) Erfinder: van Hoorn, Hendrik, 9354 XP, Zevenhuizen (NL)

(56) Entgegenhaltungen:
- NL-C- 1 003 458
- US-A- 4 218 298
- US-A- 5 833 824
- US-A- 6 117 292
- US-A- 6 153 070
- US-A1- 2002 027 074

## Beschreibung

### Technisches Gebiet

Die Erfindung betrifft einen elektrochemischen Sensor gemäss dem Oberbegriff des Anspruches 1.

### Stand der Technik

Neben den weit verbreiteten elektrochemischen Sensoren mit einem aus Glas bestehenden Sensorelement und/oder Sensorgehäuse gewinnen sogenannte "Nichtglas-Sensoren" (engl.: "non-glass sensors") zunehmend an Bedeutung. Wichtige Anwendungsbereiche solcher Sensoren umfassen beispielsweise die Messung von Konzentrationen bei Produktionsprozessen in der Nahrungsmittelindustrie. Insbesondere die Messung von pH-Werten, die bislang vornehmlich mit Glaselektroden durchgeführt wurde, ist in manchen industriellen Bereichen aufgrund von gesetzlichen Vorschriften nicht mehr zulässig oder wird dies in Zukunft nicht mehr sein. Leitgedanke ist dabei die Vermeidung der Gefahren, die sich bei einem allfälligen Bruch von Glasteilen, beispielsweise in einer Produktionskette für Nahrungsmittel, ergeben.

Bei der Konstruktion eines glaslosen elektrochemischen Sensors stellt sich einerseits das Problem, dass anstelle des üblichen Sensorgehäuses aus Glas ein solches aus einem anderen Material zu wählen ist. Hierfür eignen sich vornehmlich verschiedene Arten von Kunststoffen, wobei diese eine für die jeweilige Anwendung genügende mechanische Stabilität und chemische Resistenz und zudem möglichst gute elektrische Isolatoreigenschaften aufweisen müssen. Andererseits gilt es insbesondere bei Sensoren zur Messung des pH-Wertes, die ja üblicherweise eine Membran aus pH-Glas als wesentlichen Bestandteil der Messvorrichtung beinhalten, eine glasfreie Alternative zu finden, d.h. es muss ein anderes Messprinzip herangezogen werden.

Als glaslose ionensensitive Elemente, welche insbesondere als pH-sensitive glaslose Elemente ausgestaltet sein können, bieten sich ionensensitive Feldeffekt-Transistoren, (nachfolgend mit dem üblichen Akronym ISFET für "lon Sensitive Field Effect Transistor" bezeichnet), an. So ist in der DE 3116884 A1 ein Verfahren und eine Schaltung zur Messung der lonenaktivität in Flüssigkeiten unter Verwendung eines ISFET beschrieben. Der ISFET beinhaltet dabei eine als Transistor-Gate wirkende Isolierschicht, welche die Funktion eines ionensensitiven Oberflächenbereichs hat und die zwischen einer Source-Elektrode und einer Drain-Elektrode angeordnet ist. Eine pH-Messvorrichtung mit einer Elektrode, die einen ISFET aufweist, ist beispielsweise in der EP 63213 B1 beschrieben.

In den zitierten Dokumenten ist die Anordnung des ISFET im Sensor jeweils lediglich schematisch angedeutet. Bei der praktischen Realisierung zeigt sich allerdings, dass Einbaulage, Halterung und elektrische Kontaktierung des ISFET von erheblicher Bedeutung für die Funktionsfähigkeit des Sensors sind, da in aller Regel ein mediumdichter Abschluss von gewissen Teilen des Sensors und überdies ein Schutz des ISFET vor übermässiger mechanischer Belastung, beispielsweise beim Einsatz unter erhöhtem Druck, sichergestellt werden muss.

Gattungsgemässe Sensoren sind in US 6,117,292 und US 6,153,070 angegeben. Diese weisen ein Sensorgehäuse sowie einen darin eingebauten scheibchenförmigen ISFET mit einem rückseitigen Source-Anschluss und Drain-Anschluss und einem zum Eintauchen in ein Messmedium vorgesehenen frontseitigen ionensensitiven Oberflächenbereich auf. Die Sensoren beruhen auf einer stapelweisen Anordnung, bei welcher der ISFET gegen eine plättchenförmigen Unterlage angedrückt ist, welche gleichzeitig sowohl als mechanische Auflage wie auch als elektrische Ableitung wirkt, wobei letztere Funktion durch eine Ausgestaltung als richtungsspezifischer elektrischer Leiter erzielt wird. Zu diesem Zweck ist die Unterlage aus einer lamellenartigen Struktur von alternierenden Isolator- und Leiterschichten gebildet, die im Wesentlichen senkrecht zur Hauptebene der Unterlage verlaufen. Im Ergebnis wird damit eine elektrische Leitung senkrecht zur Hauptebene und gleichzeitig eine elektrische Isolation in einer Richtung in der Hauptebene erzielt, um ein elektrisches Abgreifen am rückseitigen Source- und am Drain-Anschluss des ISFET zu ermöglichen. Nachteilig bei diesen Sensoren sind der komplexe Aufbau und die hohen Herstellungskosten. Besonders nachteilig ist zudem, dass Source- und Drainanschluss zwangsläufig auf der Rückseite des ISFET angeordnet sein müssen, was nicht der üblichen Bauweise von ISFETs entspricht und dementsprechend Mehrkosten und eine eingeschränkte Typenwahl bedingt.
In der NL 1003458 C ist eine Bezugselektrode beschrieben, welche anstelle der üblichen Ag/AgCl-Halbzelle mit Glasfritte und leitendem Gel ein mit einer AgCl-Schicht bedecktes Ag-Plättchen aufweist, wobei über der AgCl-Schicht eine dünne SiO₂-Schicht angeordnet ist. Ein Andruckteil ist dazu vorgesehen, das Ag-Plättchen mit einer von der AgCl-Schicht abgewandten Rückfläche gegen eine Stirnfläche eines Sensorgehäuses angedrückt zu halten, wobei das Andruckteil eine zentrale Öffnung aufweist, die einen mittigen Teil der AgCl-Schicht freilässt. Zwischen dem Andruckteil und dem AgCl-Plättchen ist ein im Wesentlichen ringförmiges Dichtungselement angeordnet, welches den mittigen Teil der AgCl-Schicht mediumdicht umschliesst. In der NL 1003458 C ist erwähnt, dass das Andruckteil (dort als "kopdeel", d.h. Kopfteil bezeichnet) mittels Kleben, vorzugsweise aber durch Ultraschallschweissen am Sensorgehäuse (dort als "huls", d.h. Hülse bezeichnet) befestigt ist. Allerdings sind in der besagten Druckschrift keinerlei Angaben darüber zu finden, wie die durch Ultraschallschweissen gebildete Befestigung räumlich ausgestaltet ist und ob sie insbesondere eine umlaufende mediumdichte Verbindung bildet. Des Weiteren ist nicht angegeben, wie der Schweissvorgang durchzuführen ist. Insbesondere stellt sich beim Ultraschallschweissen wie auch bei anderen Arten von Vibrationsschweissen das Problem, dass nicht nur die zu verschweissenden Bauteile, sondern auch weitere benachbarte Bauteile in eine mehr oder weniger starke Vibrationsbewegung versetzt werden. Dies mag im Falle des dort verwendeten Ag-Plättchens tolerierbar sein; soll jedoch anstelle des Ag-Plättchens ein ISFET eingebaut werden, so würden die darauf übertragenen Vibrationen zu Brüchen oder Schichtablösungen führen. Besonders vibrationsanfällig sind zudem die bei manchen Typen von ISFETs vorliegenden Verbindungen zwischen Source- bzw. Drain-Anschluss und entsprechenden Ableitungsdrähten (sogenannte "gebondete" Anschlussdrähte). Für die in der NL 1003458 C beschriebene Bezugselektrode stellen sich diese Probleme gar nicht und dementsprechend findet sich darin auch keinerlei Hinweis zu deren Lösung. Des Weiteren ist die in der NL 1003458 C beschriebene Anordnung analog zu denjenigen der US 6,117,292 und US 6,153,070 für eine rückseitige elektrische Kontaktierung ausgelegt und somit für die besonders gebräuchlichen ISFETs mit frontseitiger Ableitung nicht geeignet.

### Darstellung der Erfindung

Aufgabe der Erfindung ist es, einen verbesserten elektrochemischen Sensor anzugeben, um insbesondere die oben genannten Nachteile zu vermeiden.

Gelöst wird diese Aufgabe durch den im Anspruch 1 definierten Sensor. Dieser hat ein Sensorgehäuse und einen ionensensitiven Feldeffekt-Transistor (ISFET), der einen Source-Anschluss und einen Drain-Anschluss sowie einen an einer Vorderfläche des ISFET angeordneten ionensensitiven Oberflächenbereich aufweist, wobei letzterer zum Eintauchen in ein Messmedium vorgesehen ist. Mittels eines Andruckteils ist der ISFET mit einer vom ionensensitiven Oberflächenbereich abgewandten Rückfläche gegen eine Stirnfläche des Sensorgehäuses angedrückt. Das Andruckteil weist eine zentrale Öffnung auf, die den ionensensitiven Oberflächenbereich des ISFET freilässt, wogegen der Source-Anschluss und der Drain-Anschluss in einem gegenüber Zutritt von Messmedium geschützten Innenbereich des Sensors angeordnet sind. Dadurch, dass das Andruckteil eine durch Vibrationsschweissen, vorzugsweise Ultraschallschweissen, gebildete umlaufende mediumdichte Verbindung mit dem Sensorgehäuse aufweist, ist eine vergleichsweise einfach herstellbare, dauerhafte und zuverlässige mechanische Verbindung zwischen dem Andruckelement und dem Sensorgehäuse gewährleistet, welche einen Durchtritt von Messmedium zwischen Andruckelement und Sensorgehäuse verhindert und damit sicherstellt, dass kein Messmedium in Kontakt mit dem Source-Anschluss und/oder dem Drain-Anschluss treten kann. Dadurch, dass der ISFET sandwichartig zwischen zwei gummielastischen Elementen angeordnet ist, wird eine Übertragung von Vibrationen vom Sensorgehäuse auf den ISFET verhindert und damit eine unerwünschte mechanische Beanspruchung und Beschädigung des ISFET beim Herstellen der umlaufenden Verbindung mittels Vibrations- bzw. Ultraschallschweissen vermieden. Dadurch, dass mindestens eines der gummielastischen Elemente einen mediumdichten Abschluss zwischen dem ionensensitiven Oberflächenbereich einerseits und dem Source-Anschluss und Drain-Anschluss andererseits bildet, wird eine kompakte Bauweise und eine einfache und kostengünstige Herstellung des Sensors erreicht. Die erfindungsgemässe Anordnung ist nicht nur für ISFET mit rückseitiger Kontaktierung, sondern insbesondere auch für die besonders gebräuchlichen und kostengünstigen ISFETs mit frontseitiger Kontaktierung geeignet.
Vorteilhafte Ausgestaltungen der Erfindung sind in den abhängigen Ansprüchen definiert.

Der erfindungsgemässe Sensor ist sowohl für eine frontseitige als auch für eine rückseitige oder allenfalls randseitige Anordnung der Anschlüsse am ISFET vorgesehen. Vorzugsweise sind jedoch gemäss Anspruch 2 der Source-Anschluss und der Drain-Anschluss an der Vorderfläche des ISFET angeordnet.

Grundsätzlich können die gummielastischen Elemente eine Mehrzahl von Formen aufweisen. Gemäss Anspruch 3 ist jedoch zumindest das abdichtende gummielastische Element als Ringdichtung ausgebildet.

Die in den Ansprüchen 4 bis 6 definierten Ausgestaltungen des Sensors stellen einerseits vorteilhafte konstruktive Varianten dar, die insbesondere für den Bau von Einstabsensoren geeignet sind. Darüber hinaus gewährleistet die Ausgestaltung nach Anspruch 5, dass der ISFET rückwärtig mechanisch abgestützt ist, was insbesondere beim Einsatz unter erhöhtem Mediumdruck vorteilhaft ist.

In einer bevorzugten Ausführungsform weist das Sensorgehäuse einen in einer mittigen Mündung der Stirnfläche endenden Kanal auf, wobei sich die Mündung vollumfänglich auf der mediumabgewandten Seite des mediumdichten Abschlusses befi ndet.

In einer weiter entwickelten Version dieser Ausführungsform ist der Kanal mit einer Vergussmasse befüllt, welche bis zur Rückfläche des ISFET reicht und eine mechanische Abstützung für den ISFET bildet. Vorzugsweise das Sensorgehäuse im Wesentlichen rohrförmig ausgebildet.

Für manche Anwendungen bietet sich eine im Wesentlichen zylindersymmetrische Ausbildung des Sensors an, bei welcher der ISFET im Wesentlichen rechtwinkelig gegenüber einer Längsachse des Sensorgehäuses ausgerichtet ist. Gemäss Anspruch 7 ist hingegen der ionensensitive Oberflächenbereich des ISFET gegenüber der besagten Längsachse des Sensorgehäuses schiefwinkelig angeordnet. Dadurch kann in strömenden Messmedien eine strömungstechnisch optimale Ausrichtung des ionensensitiven Bereichs des Sensors erreicht werden. Die schiefwinkelige Anordnung ist überdies besonders vorteilhaft, wenn der Sensor vertikal von oben her eingebaut wird, kann doch dabei vermieden werden, dass sich aufsteigende Gasblasen am ISFET verfangen und dort eine unerwünschte Gastasche bilden.

Gemäss Anspruch 8 ist der Sensor mit einem Temperaturfühler ausgestattet, was eine Korrektur der Sensor-Messwerte bezüglich der am ISFET herrschenden Temperatur erlaubt.

Grundsätzlich können ISFETs als spezifische Sensorelemente für die verschiedensten lonenspezies ausgestaltet sein. Gemäss Anspruch 9 ist der ISFET als pH-sensitives Element ausgestaltet.

Der Sensor kann zusammen mit irgendeiner externen Bezugselektrode eingesetzt werden. Vorteilhafterweise ist er nach Anspruch 10 mit einer Bezugselektrode ausgestattet, woraus sich eine kompakte und einfach bedienbare Einstab-Anordnung ergibt.

### Kurze Beschreibung der Zeichnungen

Ausführungsbeispiele der Erfindung werden nachfolgend anhand der Zeichnungen näher beschrieben, dabei zeigen:
- Figur 1: einen elektrochemischen Sensor, im Längsschnitt;
- Figur 2: einen weiteren elektrochemischen Sensor, vor dem Zusammenbau, im Längsschnitt;
- Figur 3: einen weiteren elektrochemischen Sensor, im Längsschnitt.

### Wege zur Ausführung der Erfindung

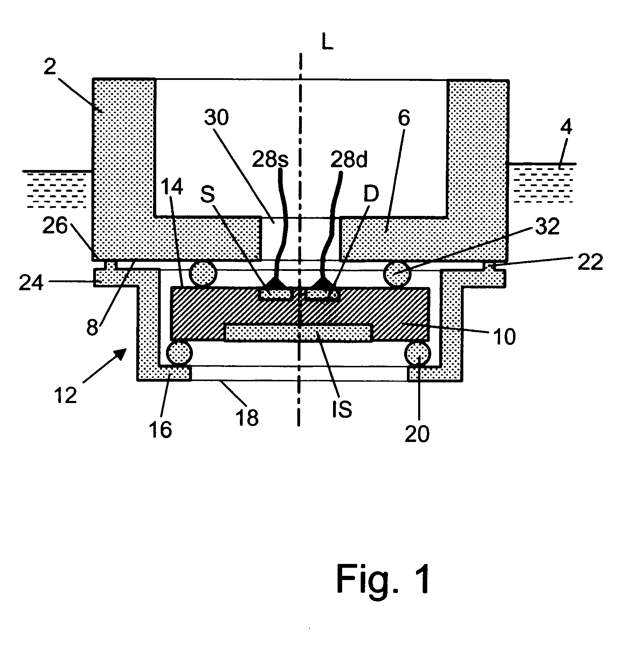

Der in der Figur 1 dargestellte Sensor beinhaltet ein im wesentlichen zylinderförmiges Sensorgehäuse 2 aus Polyetheretherketon (PEEK), das in ein Messmedium 4 eingetaucht ist und das eine Bodenwandung 6 mit einer äusseren Stirnfläche 8 aufweist. Der Sensor ist mit einem scheibenförmigen ionen-sensitiven Feldeffekt-Transistor (ISFET) 10 ausgestattet, der rückseitig einen Source-Anschluss S und einen Drain-Anschluss D und frontseitig einen mit dem Messmedium in Kontakt stehenden ionensensitiven Oberflächenbereich IS aufweist. Mittels eines hülsenartigen Andruckteils 12, das aus demselben Material wie das Sensorgehäuse 2 besteht, ist der ISFET 10 mit seiner vom ionensensitiven Oberflächenbereich IS abgewandten Rückfläche 14 in Richtung gegen die Stirnfläche 8 des Sensorgehäuses 2 angedrückt. Zu diesem Zweck ist das Andruckteil 12 auf seiner vom Sensorgehäuse 2 abgewandten Seite mit einem einwärts reichenden Bodenkragen 16 ausgestattet, der den ISFET 10 randständig übergreift, während eine zentrale Öffnung 18 des Andruckteils 12 den ionensensitiven Oberflächenbereich IS freilässt. Zwischen dem Bodenkragen 16 und dem ISFET 10 ist ein erstes gummielastisches Element 20, beispielsweise aus einem Ethylen-Propylen-Dien-Terpolymer (EPDM) oder allenfalls aus einem Fluorelastomer wie Viton® , angeordnet. Im gezeigten Beispiel besteht das erste gummielastische Element 20 aus einem Dichtungsring und bildet zugleich einen den ionensensitiven Oberflächenbereich IS umschliessenden und den Source-Anschluss S und Drain-Anschluss D ausschliessenden mediumdichten Abschluss. Mit anderen Worten befinden sich - wie der Figur 1 entnehmbar - der ionensensitive Oberflächenbereich einerseits und der Source- und Drain-Anschluss andererseits auf unterschiedlichen Seiten des durch den Dichtungsring 20 gebildeten mediumdichten Abschlusses.

Das Andruckteil 12 weist eine durch Ultraschallschweissen gebildete umlaufende Verbindung 22 mit dem Sensorgehäuse 2 auf. Im gezeigten Beispiel befindet sich die umlaufende Verbindung 22 zwischen einem auswärts gerichteten Kopfkragen 24 des Andruckteils 12 und einer ringflächigen Randzone 26 der Stirnfläche 8 des Sensorgehäuses 2. Wie zudem aus der Figur 1 hervorgeht, wird durch den Dichtungsring 20 und die umlaufende Verbindung 22 verhindert, dass Messmedium 4 in Kontakt mit dem Source-Anschluss S und dem Drain-Anschluss D treten kann. Letztere Anschlüsse befinden sich also in einem vor Zutritt von Messmedium geschützten Innenbereich des Sensors.

Am Source-Anschluss S und Drain-Anschluss D ist ein zugeordneter Ableitungsdraht 28s bzw. 28d angeschlossen, wobei die Ableitungsdrähte durch eine Öffnung 30 der Bodenwandung 6 zu einer nicht dargestellten Messvorrichtung geführt sind.

Zwischen der Rückfläche 14 des ISFET 10 und der Stirnfläche 8 des Sensorgehäuses 2 ist ein zweites gummielastisches Element 32 angeordnet, so dass der ISFET 10 sandwichartig zwischen den beiden gummielastischen Elementen 20 und 32 gelagert ist. Mit dieser Anordnung wird eine Übertragung von Vibrationsbewegungen vom Sensorgehäuse 2 bzw. vom Andruckteil 12 auf den ISFET 10 weitgehend vermieden, was insbesondere beim Zusammenbau des Sensors, nämlich bei der Bildung der umlaufenden Verbindung 22 mittels Ultraschallschweissen oder einer anderen geeigneten Art von Vibrationsschweissen bedeutsam ist. Denn während diese Art des Verschweissens des Andruckteils 12 und Sensorgehäuses 2 erfordert, dass zumindest die im Bereich der zu bildenden Verbindung befindlichen Bauteile in eine hochfrequente Vibrationsbewegung versetzt werden, kann die Übertragung dieser Vibration auf den ISFET 10 leicht zu dessen Beschädigung führen.

Im Beispiel der Figur 1 sind sowohl der Source-Anschluss S als auch der Drain-Anschluss D in einem mittigen Bereich der Rückfläche 14 des ISFET 10 angeordnet. Dementsprechend ist es für die Abdichtung des Sensors an sich unerheblich, welches der beiden gummielastischen Elemente den mediumdichten Abschluss bildet. Es ist auch möglich, beide gummielastischen Elemente zur Bildung des mediumdichten Abschlusses zu verwenden; insbesondere können zwei identische Dichtungsringe, beispielsweise zwei Rundschnur-Ringe desselben Materials und allenfalls derselben Abmessungen eingesetzt werden.

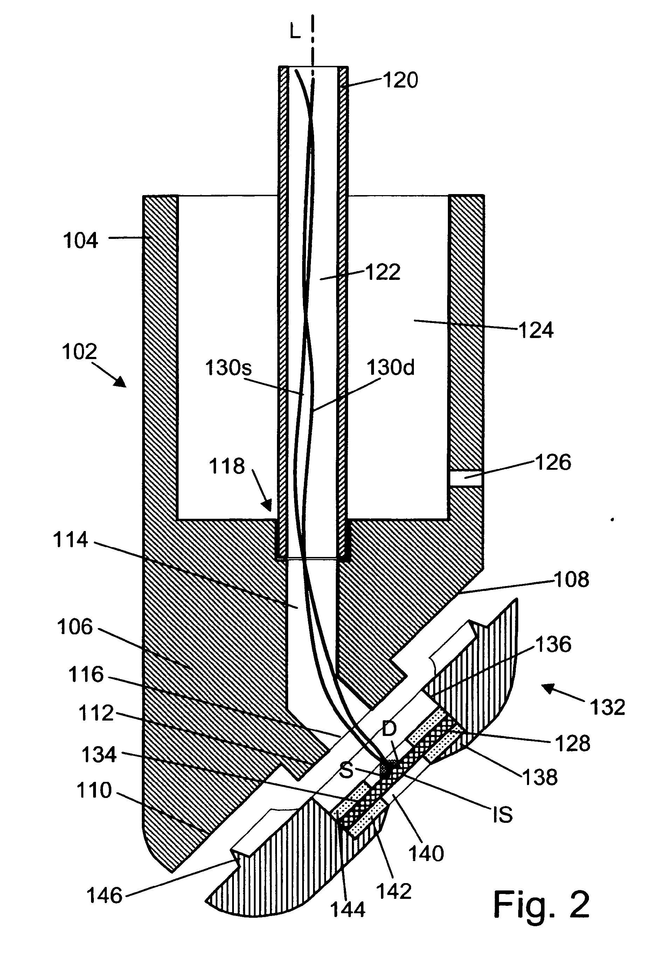

Die Figur 2 zeigt einen weiteren Sensor vor dem Zusammenbau. Dieser umfasst ein Sensorgehäuse 102, beispielsweise aus PEEK, mit einem rohrförmigen Sensorschaft 104 sowie einem Bodenabschnitt 106, welcher eine äussere Stirnfläche 108 aufweist. Die Stirnfläche 108 ist gegenüber der Längsachse L des Sensorschafts 104 schiefwinkelig, beispielsweise um einen Winkel von 45° geneigt, und weist eine ringflächige Randzone 110 sowie eine gegenüber dieser vorstehende, ebenfalls ringflächige Kernzone 112 auf. Der Bodenabschnitt 106 ist mit einer mittigen Bohrung 114 ausgestattet, welche einerseits in einer Stirnmündung 116 der Kernzone 112 und andererseits in einer Innenmündung 118 des Bodenabschnitts 106 endet. Ein in die Innenmündung 118 mediumdicht eingelegtes Innenrohr 120, beispielsweise ebenfalls aus PEEK gebildet, definiert einen Sensor-Innenraum 122 sowie einen zwischen dem Innenrohr 120 und dem Sensorschaft 104 liegenden Sensor-Zwischenraum 124. Insbesondere ist der Sensor-Zwischenraum 124 für eine Bezugselektrode vorgesehen; eine Durchgangsbohrung 126 im Sensorschaft 104 dient dabei in an sich bekannter Weise zur Aufnahme eines Diaphragmas.

Des weiteren umfasst der Sensor einen scheibenförmigen ISFET 128 mit einem rückseitigen Source-Anschluss S und Drain-Anschluss D und daran angeschlossenen Ableitungsdrähten 130s und 130d sowie einem frontseitigen ionensensitiven Oberflächenbereich IS, der zum Eintauchen in ein Messmedium vorgesehen ist. Die Ableitungsdrähte 130s und 130d sind in durch die Stirnmündung 116, die mittige Bohrung 114 und das Innenrohr 120 geführt, um mit einer nicht dargestellten Anzeigevorrichtung verbunden zu werden.

Ein aus demselben Material wie das Sensorgehäuse gebildetes Andruckteil 132 ist dazu vorgesehen, den ISFET 128 mit seiner vom ionensensitiven Oberflächenbereich IS abgewandten Rückfläche 134 in Richtung gegen die Stirnfläche 108 des Sensorgehäuses 102 anzudrücken. Zu diesem Zweck weist das Andruckteil 132 auf seiner (im zusammengebauten Zustand) dem Sensorgehäuse 102 zugewandten Seite eine zentrale Ausnehmung 136 auf, welche zur Aufnahme des ISFET 128 vorgesehen ist, und deren Weite den Aussendurchmesser der vorstehenden Kernzone 112 übersteigt. Auf seiner vom Sensorgehäuse abgewandten Seite ist das Andruckteil 132 mit einem einwärts reichenden Kragen 138 ausgestattet, der die zentrale Ausnehmung 136 und den darin angeordneten ISFET 128 randständig übergreift, während eine zentrale Öffnung 140 des Andruckteils 132 den ionensensitiven Oberflächenbereich IS freilässt.

Wie aus der Figur 2 ersichtlich, ist der ISFET 128 sandwichartig zwischen einem ersten gummielastischen Element 142 und einem zweiten gummielastischen Element 144 gelagert, welche beide als Flachringe ausgebildet sind und beispielsweise aus einem Fluorelastomer bestehen. Vorteilhafterweise entsprechen die Aussendurchmesser der beiden gummielastischen Elemente 142 und 144 im wesentlichen dem Innendurchmesser der zentralen Ausnehmung 136, der seinerseits den Aussendurchmesser der vorstehenden Kernzone 112 nur geringfügig übertrifft, um einen satten Sitz der verschiedenen Bauteile zu ergeben. Demgegenüber sollte der ISFET 128 nicht satt in der zentralen Ausnehmung 136 sitzen, da ansonsten beim Ultraschallschweissen eine unerwünschte Übertragung von Vibrationen auf den ISFET 128 stattfindet.

Das Andruckteil 132 weist auf seiner dem Sensorgehäuse zugewandten Seite einen ausserhalb der zentralen Ausnehmung 136 verlaufenden ringförmigen, klingenartigen Vorsprung 146 auf, welcher als Energie-Richtungsgeber zur Bildung einer Schweissnaht mit dem Sensorgehäuse 102 vorgesehen ist. In an sich bekannter Weise kann in der Randzone 110 der Stirnfläche 108 eine zur Aufnahme des Vorsprungs 146 ausgebildete Ringnut vorgesehen sein, welche als Ausrichthilfe beim Zusammenbau des Sensors dient. Alternativ kann der klingenartige Vorsprung an der Stirnfläche 108 vorgesehen sein, wobei dann eine allfällige zugeordnete Nut am Andruckteil 132 auszubilden ist.

Beim Zusammenbau des Sensors wird ausgehend von der in Figur 2 dargestellten Situation, in welcher die sandwichartige Anordnung von ISFET 128 und zwei gummielastischen Elementen bereits in der zentralen Ausnehmung 136 des Andruckteils 132 eingelegt ist, wie folgt vorgegangen. Zunächst wird das Andruckteil 132 gegen die Stirnfläche 108 angelegt, wobei die zentrale Ausnehmung 136 auf die vorstehende Kernzone 112 gesteckt wird. Dabei kommt der klingenartige Vorsprung 146 in Berührung mit der Randzone 110 des Sensorgehäuses 102. In der Folge wird eine Ultraschallverschweissung vorgenommen, indem die unmittelbare Umgebung des klingenartigen Vorsprungs 146 mit Ultraschall beaufschlagt wird. Dies führt zu einem lokalen Verschmelzen des Vorsprungs 146 und des damit in Berührung stehenden Teils der Randzone 110, wobei ein umlaufender mediumdichter Abschluss in Form einer Schweissnaht gebildet wird.

Die beiden gummielastischen Elemente 142 und 144 dienen zum einen der Vermeidung einer Vibrationsübertragung auf den dazwischen liegenden ISFET 128. Darüber hinaus ist jedoch mindestens eines der beiden gummielastischen Elemente dazu vorgesehen, einen mediumdichten Abschluss des Sensors zu bilden. Dementsprechend ist es erforderlich, dass im zusammengebauten Zustand, d.h. nach dem Ultraschallschweissen, ein gewisser Anpressdruck auf dem dichtenden Element vorliegt. Dies lässt sich insbesondere durch Wahl der Dicke der beiden gummielastischen Elemente 142 und 144 erreichen, wenn die Abmessungen der übrigen Bauteile vorgegeben sind. Dies setzt allerdings voraus, dass die Dicke der beim Ultraschallschweissen gebildeten Schweissnaht voraussehbar ist. Zweckmässigerweise wird diese anhand von Vorversuchen mit unterschiedlichen Parameterwerten der Ultraschallschweissung ermittelt.

Nach dem Ultraschallschweissen wird, falls nicht bereits vorher erfolgt, das Innenrohr 120 in die Innenmündung 118 des Bodenabschnitts 106 eingelegt und beispielsweise mittels Epoxy-Kleber mediumdicht mit dem Rand der Innenmündung verbunden.

Bei gewissen Anwendungen des Sensors übertrifft der Druck im Messmedium denjenigen im Sensorinnenraum. Dies führt zu einer Druckbelastung des ISFET, welche eine Verfälschung der Messwerte hervorrufen kann. Um dies zu vermeiden, ist es zweckmässig, den ISFET rückwärtig mit einer mechanischen Abstützung zu versehen. Da dies jedoch dem Erfordernis einer vibrationsisolierten Lagerung des ISFET während des Ultraschallschweissens zuwiderläuft, muss die mechanische Abstützung erst nach dem Ultraschallschweissen angebracht werden. Vorteilhafterweise wird dies erreicht, indem der Sensorinnenraum vom Innenrohr 120 her mit einem Epoxy-Kleber bis zur Rückfläche 134 des ISFET 128 befüllt wird, welcher nach dem Aushärten als mechanische Abstützung wirkt. Dieses Ergebnis ist im Rahmen des folgenden Ausführungsbeispiels illustriert.

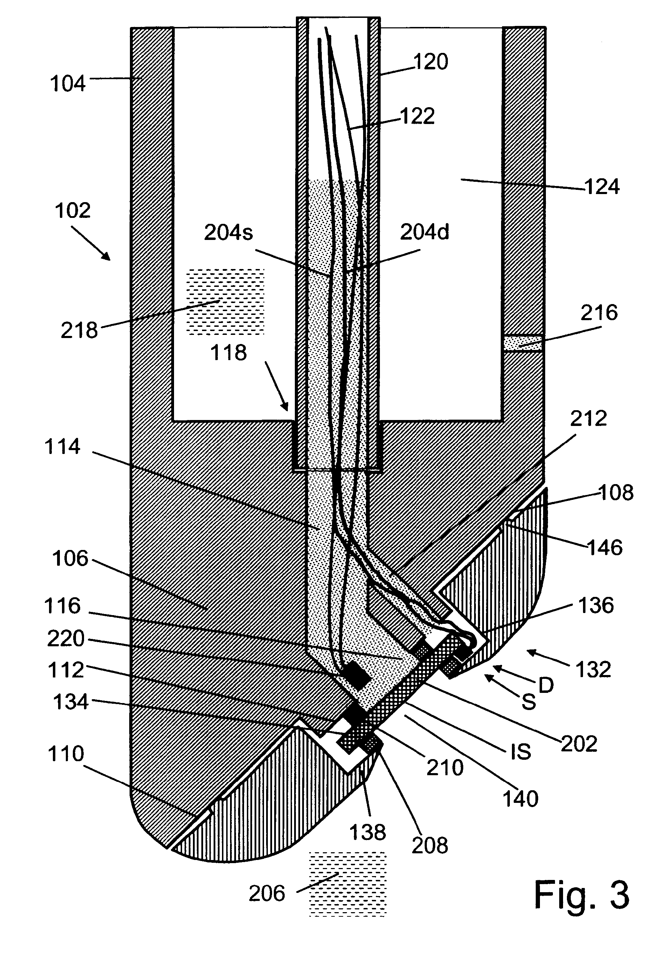

In der Figur 3 ist eine weitere Ausgestaltung eines Sensors in zusammengebautem Zustand dargestellt. Dieser ist weitgehend wie der Sensor der Figur 2 ausgestaltet, und dementsprechend sind übereinstimmende Teile in den Figuren 2 und 3 mit denselben Bezugszeichen versehen und hier nicht nochmals erwähnt. Im Unterschied zum vorangehenden Beispiel sind jedoch der Source-Anschluss S und der Drain-Anschluss D nicht rückseitig, sondern frontseitig am scheibenförmigen ISFET 202 angeordnet, und zwar in einem Randbereich der Frontfläche. Dementsprechend sind auch die zugehörigen Ableitungsdrähte 204s und 204d frontseitig am ISFET 202 angeschlossen. Der ionensensitive Oberflächenbereich IS ist wie bei den anderen Beispielen ebenfalls frontseitig angeordnet und im vorliegenden Fall in ein Messmedium 206 getaucht. Der ISFET 202 ist sandwichartig zwischen einem äusseren ersten gummielastischen Element 208 und einem inneren zweiten gummielastischen Element 210 angeordnet, die beide als Elastomer-Flachringe ausgebildet sind. Der Aussendurchmesser der beiden gummielastischen Elemente 208 und 210 ist kleiner als der Innendurchmesser der zentralen Ausnehmung 136 des Andruckteils 132, um einen Durchlass für die Ableitungsdrähte 204s und 204d freizulassen.

Der Bodenabschnitt 106 weist neben der mittigen Bohrung 114 eine seitliche Bohrung 212 auf, die einerseits in einem randständigen Bereich der Kernzone 112 und andererseits in den Sensor-Innenraum 122 geführt ist, beispielsweise indem sie wie hier dargestellt in die mittige Bohrung 114 einmündet. Die seitliche Bohrung 212 bildet einen Durchgang für die Ableitungsdrähte 204s und 204d, um diese insbesondere vom zweiten gummielastischen Element 210 freizuhalten.

Wie insbesondere anhand der Figur 3 nachvollziehbar ist, bedingt die seitliche Abführung der Ableitungsdrähte 204s und 204d, dass das äussere, erste gummielastische Element 208 als mediumdichter Abschluss gegenüber dem Messmedium 206 wirkt.

Wie bereits im Zusammenhang mit dem Sensor der Figur 2 erläutert, ist der Sensorinnenraum von Innenrohr 120 her durch die mittige Bohrung 114 wie auch durch die seitliche Bohrung 212 bis zur Rückfläche 134 des ISFET 202 mit einer Vergussmasse 214, beispielsweise auf Basis eines Epoxy-Klebers, hinterfüllt.

Der Sensor der Figur 3 ist als Einstab-Messkette, beispielsweise zur Messung des pH-Wertes ausgestaltet. Zu diesem Zweck ist der ISFET 202 als pH-sensitives Element ausgestaltet, während im Sensor-Zwischenraum 124 eine Bezugselektrode, beispielsweise eine hier nicht dargestellte Ag/AgCl-Elektrode angeordnet ist. Die seitliche Bohrung 126 im Sensorschaft 104 enthält ein Diaphragma 216, beispielsweise ein Keramikdiaphragma, welches als Stromschlüssel zwischen dem Messmedium 206 und dem im Zwischenraum 124 befindlichen Bezugselektrolyten 218 wirkt.

Der Sensor der Figur 3 ist zudem mit einem Temperaturfühler 220, beispielsweise einem Platinwiderstand, ausgestattet, der ebenfalls in die Vergussmasse 214 eingebettet ist und sich im Bereich der Stirnmündung 116 befindet. Damit lässt sich die am ISFET herrschende Temperatur überwachen und erforderlichenfalls eine entsprechende Korrektur der Sensor-Messwerte vornehmen.

Die um einen Winkel von ungefähr 45° gegenüber der Sensorlängsachse L geneigte Ausrichtung der Gehäusestirnfläche, und damit auch des ISFET, sowie die abgerundeten Kantenbereiche bei den in den Figuren 2 und 3 gezeigten Ausgestaltungen tragen dazu bei, im Falle eines vorbeiströmenden Messmediums unerwünschte Turbulenzen oder andere störende Strömungseffekte zu vermeiden. Ausserdem wird bei vertikaler Einbaulage des Sensors durch die schiefwinkelige Anordnung des ISFET vermieden, dass aufsteigende Gasblasen sich am ionensensitiven Bereich ansammeln und dort eine störende Gastasche bilden können.

Die oben beschriebenen Sensoren zeichnen sich dadurch aus, dass sie ohne weiteres durch Behandlung mit heissem Wasser oder Wasserdampf sterilisiert werden können, ohne dabei beschädigt zu werden. Ein weiterer Vorteil besteht darin, dass die Sensoren in dem Bereich, der in Kontakt mit dem Messmedium treten kann, keinerlei Klebestellen aufweisen. Dadurch wird einerseits eine unerwünschte Zersetzung von Klebestoff durch Einwirkung des Messmediums vermieden und andererseits ein Sensoreinsatz im Zusammenhang mit Nahrungsmitteln, Getränken und dergleichen begünstigt, da ein Kontakt von toxischen Klebestoff-Komponenten mit dem Messgut ausgeschlossen ist.

Die geschilderten Ausführungsbeispiele sind in Form, Gestaltung, Materialien und Dimensionen nur exemplarisch zu verstehen. Der Fachmann wird je nach Bedarf auch abgewandelte Ausgestaltungen, die unter den folgenden Ansprüchen fallen, heranziehen.

### Bezugszeichenliste

- 2: Sensorgehäuse
- 4: Messmedium
- 6: Bodenwandung von 2
- 8: Stirnfläche von 2
- 10: ISFET
- 12: Andruckteil
- 14: Rückfläche von 10
- 16: Bodenkragen von 12
- 18: zentrale Öffnung von 12
- 20: erstes gummielastisches Element
- 22: umlaufende Verbindung zwischen 12 und 2
- 24: Kopfkragen von 12
- 26: Randzone von 8
- 28s, 28d: Ableitungsdrähte
- 30: Öffnung von 6
- 32: zweites gummielastisches Element
- 102: Sensorgehäuse
- 104: Sensorschaft von 102
- 106: Bodenabschnitt von 102
- 108: Stirnfläche von 106
- 110: Randzone von 108
- 112: Kernzone von 108
- 114: Bohrung von 106
- 116: Stirnmündung von 114
- 118: Innenmündung von 114
- 120: Innenrohr
- 122: Sensor-Innenraum
- 124: Sensor-Zwischenraum
- 126: Durchgangsbohrung
- 128: ISFET
- 130s, 130d: Ableitungsdrähte
- 132: Andruckteil
- 134: Rückfläche
- 136: zentrale Ausnehmung von 132
- 138: Kragen von 132
- 140: zentrale Öffnung von 132
- 142: erstes gummielastisches Element
- 144: zweites gummielastisches Element
- 146: klingenartiger Vorsprung von 132
- 202: ISFET
- 204s, 204d: Ableitungsdrähte
- 206: Messmedium
- 208: erstes gummielastisches Element
- 210: zweites gummielastisches Element
- 212: seitliche Bohrung von 106
- 214: Vergussmasse
- 216: Diaphragma
- 218: Bezugselektrolyt
- 220: Temperatursensor
- S: Source-Anschluss
- D: Drain-Anschluss
- lS: ionensensitiver Oberflächenbereich
- L: Längsachse

## Patentansprüche

1. Elektrochemischer Sensor, mit einem Sensorgehäuse (2; 102), einem ionen-sensitiven Feldeffekt-Transistor (ISFET), der einen Source-Anschluss (S) und einen Drain-Anschluss (D), einen an einer Vorderfläche des ISFET angeordneten ionensensitiven Oberflächenbereich (IS), welche zum Eintauchen in ein Messmedium (4; 206) vorgesehen ist, und eine vom ionensensitiven Oberflächenbereich (IS) abgewandte Rückseite (14; 134) aufweist, und mit einem Andruckteil (12; 132), welches den ISFET mit seiner Rückfläche (14; 134) gegen eine äussere Stirnfläche (8; 108) des Sensorgehäuses (2;102) andrückt und welches eine zentrale Öffnung (18; 140) aufweist, die den ionensensitiven Oberflächenbereich (IS) des ISFET freilässt, wobei der Source-Anschluss (S) und der Drain-Anschluss (D) in einem Innenbereich des Sensors angeordnet sind, welcher gegenüber Zutritt von Messmedium geschützt ist, **dadurch gekennzeichnet, dass** das Andruckteil (12; 132) eine umlaufende mediumdichte Verbindung (22; 146) mit dem Sensorgehäuse (2; 102) aufweist, welche durch Vibrationsschweissen, vorzugsweise Ultraschallschweissen gebildet ist, und dass der ISFET sandwichartig zwischen zwei gummielastischen Elementen (20, 32; 142, 144; 208, 210) angeordnet ist, wobei mindestens eines der gummielastischen Elemente einen mediumdichten Abschluss zwischen dem ionensensitiven Oberflächenbereich (IS) einerseits und dem Source-Anschluss (S) und Drain-Anschluss (D) andererseits bildet.

2. Sensor nach Anspruch 1, **dadurch gekennzeichnet, dass** der Source-Anschluss (S) und der Drain-Anschluss (D) an der Vorderfläche des ISFET angeordnet sind.

3. Sensor nach Anspruch 1 oder 2, **dadurch gekennzeichnet, dass** das mindestens eine gummielastische Element als Ringdichtung ausgebildet ist.

4. Sensor nach einem der Ansprüche 1 bis 3, **dadurch gekennzeichnet, dass** das Sensorgehäuse (2; 102) einen in einer mittigen Mündung (30; 116) der Stirnfläche endenden Kanal (114) aufweist, wobei sich die Mündung (30; 116) vollumfänglich auf der mediumabgewandten Seite des mediumdichten Abschlusses (22; 146) befindet.

5. Sensor nach Anspruch 4, **dadurch gekennzeichnet, dass** der Kanal (114) mit einer Vergussmasse (214) befüllt ist, welche bis zur Rückfläche (134) des ISFET reicht und eine mechanische Abstützung für den ISFET bildet.

6. Sensor nach einem der Ansprüche 1 bis 5, **dadurch gekennzeichnet, dass** das Sensorgehäuse (2; 102) im Wesentlichen rohrförmig ausgebildet ist.

7. Sensor nach Anspruch 6, **dadurch gekennzeichnet, dass** der ionensensitive Oberflächenbereich (IS) des ISFET gegenüber einer Längsachse (L) des Sensorgehäuses (102) schiefwinkelig angeordnet ist.

8. Sensor nach einem der Ansprüche 1 bis 7, **dadurch gekennzeichnet, dass** er einen Temperaturfühler (220) zur Bestimmung der Temperatur des ISFET aufweist.

9. Sensor nach einem der Ansprüche 1 bis 8, **dadurch gekennzeichnet, dass** der ISFET als pH-sensitives Element ausgestaltet ist.

10. Sensor nach einem der Ansprüche 1 bis 9, **dadurch gekennzeichnet, dass** er mit einer Bezugselektrode (114, 216, 218) ausgestattet ist.

## Claims

1. Electrochemical sensor having a sensor housing (2; 102); further having an ion-sensitive field effect transistor (ISFET) with a source connection (S), a drain connection (D), an ion-sensitive surface area (IS) arranged on a front side of the ISFET and designed for immersion in a measuring medium (4; 206), and a rear side (14; 134) facing away from the ion-sensitive surface area (IS); further having a clamping element (12; 132) which clamps the ISFET with its rear side (14; 134) against an outer end surface (8; 108) of the sensor housing (2; 102) and which has a central opening (18; 140) leaving the ion-sensitive surface area (IS) exposed; wherein the source connection (S) and the drain connection (D) are arranged in an interior space of the electrochemical sensor, said interior space being protected from contact with the measuring medium; **characterized in that** said clamping element (12; 132) has a leak-tight circular connection (22; 146) to the sensor housing (2; 102) formed by vibratory welding, preferably ultrasonic welding, and that the ISFET is sandwiched between two rubber-elastic elements (20, 32; 142, 144; 208, 210), wherein at least one of the rubber-elastic elements forms a leak-tight seal against penetration of the measuring medium between the ion-sensitive surface area (IS) to said source connection (S) and said drain connection (D).

2. Sensor according to claim 1, **characterized in that** the source connection (S) and the drain connection (D) are arranged on the front surface of the ISFET.

3. Sensor according to claim 1 or 2, **characterized in that** the at least one rubber-elastic element is configured as a ring seal.

4. Sensor according to one of the claims 1 to 3, **characterized in that** the sensor housing (2; 102) has a channel (114) ending in a central opening (30; 116) of the end surface, wherein the central opening (30; 116) is located entirely to the side of the leak-tight connection (22; 146) facing away from the medium.

5. Sensor according to claim 4, **characterized in that** the channel (114) is filled with a potting compound (214) which extends up to the rear surface (134) of the ISFET and forms a mechanical support for the ISFET.

6. Sensor according to one of the claims 1 to 5, **characterized in that** the sensor housing (2; 102) is of a substantially tubular shape.

7. Sensor according to claim 6, **characterized in that** the ion-sensitive surface area (IS) of the ISFET is oriented at an oblique angle relative to a longitudinal axis (L) of the sensor housing (102).

8. Sensor according to one of the claims 1 to 7, **characterized in that** said sensor comprises a temperature sensor (220) for measuring a temperature of the ISFET.

9. Sensor according to one of the claims 1 to 8, **characterized in that** the ISFET is configured as a pH-sensitive element.

10. Sensor according to one of the claims 1 to 9, **characterized in that** said sensor comprises a reference electrode (114, 216, 218).

## Revendications

1. Capteur électrochimique, comprenant un boîtier de capteur (2 ; 102), un transistor à effet de champ sensible aux ions (ISFET), qui présente un raccordement de source (S) et un raccordement de drain (D), une zone de surface sensible aux ions (IS), disposée sur une surface avant du ISFET, qui est prévu pour l'immersion dans un fluide de mesure (4 ; 206), et un côté arrière (14 ; 134) opposé à la zone de surface sensible aux ions (IS); et une partie de pression (12 ; 132), qui appuie l' ISFET avec sa surface arrière (14 ; 134) contre une surface avant (8 ; 108) extérieure du boîtier de capteur (2 ; 102) et qui présente une ouverture (18 ; 140) centrale, laquelle libère la zone de surface sensibles aux ions (IS) du ISFET, le raccordement de source (S) et le raccordement de drain (D) étant disposés dans une zone intérieure du capteur, laquelle est protégée vis-à-vis de l'arrivée du fluide de mesure, **caractérisé en ce que** la partie de pression (12 ;132) présente une liaison (22 ; 146) périphérique et étanche au fluide avec le boîtier de capteur (2 ; 102), qui est formée par soudage avec vibration, de préférence soudage par ultrasons, et **en ce que** le ISFET est disposé à la façon d'un sandwich entre deux éléments (20, 32 ; 142, 144 ; 208, 210) élastiques comme du caoutchouc, au moins l'un des éléments élastiques comme du caoutchouc formant une terminaison étanche au fluide entre la zone de surface sensible aux ions (IS) d'une part le raccordement de source (S) et le raccordement de drain (D) d'autre part.

2. Capteur selon la revendication 1, **caractérisé en ce que** le raccordement de source (S) et le raccordement de drain (D) sont disposés sur la surface avant du ISFET.

3. Capteur selon la revendication 1 ou 2, **caractérisé en ce que** le au moins un élément élastique comme du caoutchouc est conçu comme un joint annulaire.

4. Capteur selon l'une quelconque des revendications 1 à 3, **caractérisé en ce que** le boîtier de capteur (2, 102) présente un canal (114) se terminant dans un orifice (30 ; 116) central de la surface avant, l'orifice (30, 116) se trouvant sur toute la périphérie sur le côté opposé au fluide de la terminaison (22, 146) étanche au fluide.

5. Capteur selon la revendication 4, **caractérisé en ce que** le canal (114) est rempli d'une masse de scellement (214) qui va jusqu'à la surface arrière (134) du ISFET et forme un soutien mécanique pour le ISFET.

6. Capteur selon l'une quelconque des revendications 1 à 5, **caractérisé en ce que** le boîtier de capteur (2 ; 102) est conçu sensiblement en forme de tube.

7. Capteur selon la revendication 6, **caractérisé en ce que** la zone de surface sensible aux ions (IS) du ISFET est disposée par rapport à un axe longitudinal (L) du boîtier de capteur (102) en formant un angle oblique.

8. Capteur selon l'une quelconque des revendications 1 à 7, **caractérisé en ce qu'**il présente une sonde de température (220) pour déterminer la température du ISFET.

9. Capteur selon l'une quelconque des revendications 1 à 8, **caractérisé en ce que** le ISFET est conçu comme un élément sensible au pH.

10. Capteur selon l'une quelconque des revendications 1 à 9, **caractérisé en ce qu'**il est équipé d'une électrode de référence (114, 216, 218).
